# EUROPEAN PATENT SPECIFICATION

(11) **EP 4 254 933 B1**
(45) Date of publication and mention of the grant of the patent: **22.10.2025**
(21) Application number: 22165073.2
(22) Date of filing: 29.03.2022
(51) Int. Cl.: H04N 23/54, B60R 11/04, H04N 23/55, H04N 23/57, H05K 1/02, H05K 1/11

(54) **A VEHICLE CAMERA CIRCUIT BOARD**
FAHRZEUGKAMERALEITERPLATTE
CARTE DE CIRCUIT DE CAMÉRA DE VÉHICULE

(43) Date of publication of application: 04.10.2023
(73) Proprietor: Magna Electronics Sweden AB, 447 37 Vårgårda (SE)
(72) Inventor: WIGREN, Roger, 447 37 Vårgårda (SE); FREDRIKSSON, Peter, 447 37 Vårgårda (SE); KNUTSSON, Per, 447 34 Vårgårda (SE); PERSSON, Madeleine, 583 30 Linköping (SE); LIND, Tobias, 447 34 Vårgårda (SE); STJÄRNSTRÖM, Tobias, 447 34 Vårgårda (SE)
(74) Representative: Westpatent AB

(56) References cited:
- CN-U- 210 274 240
- US-A1- 2009 244 361
- US-A1- 2014 002 659
- US-A1- 2021 041 768
- US-A1- 2021 185 202
- US-A1- 2022 030 145

## Description

The present disclosure relates to a vehicle camera circuit board comprising a first main side and a second main side. The first main side comprises an imaging sensor and a contact area that is adapted to face a contact part of a lens assembly.

The present disclosure also relates to a vehicle camera module comprising such a vehicle camera circuit board.

Many vehicle environment detection systems comprise one or more sensors such as for example radar sensor, LIDAR sensors, ultrasonic sensors and digital camera devices. These are used for collecting data used for safety arrangements as well as for driver assistance systems. A camera device is adapted to collect images of the surroundings, and may be used to identify landmarks.

For a digital camera device that can be in the form of, or comprised in, a vehicle imaging system, a camera module is mounted to a camera housing. The camera module comprises a lens assembly and a PCB to which an image sensor and associated components are mounted.

Efficient production of digital camera devices is desired, where essential imaging components are the lens and the image sensor, and these need to be mounted firmly and securely to each other. This can be done by various methods, e.g., by gluing, soldering or screwing. The image sensor is generally mounted on a flat substrate that allows electric connection between the image sensor and a peripheral connector, typically a FR-4 PCB backplate that constitutes a vehicle camera circuit board. The vehicle camera circuit board can be positioned and attached to the lens by active alignment or just by passively fitting the parts together. The mechanical interface between the lens and the vehicle camera circuit board is here defined as the supporting interface.

Typically, a vehicle camera device is placed in an upper center part of the windshield among other sensors (such as Rain Sensors, Lidar, etc.) within a confined volume encapsulated by a protective shroud. In order to have a camera device that is not occupying too much of the available volume, it is important that the design allows for a small and compact solution.

A vehicle camera device is a precise measuring tool for determining the position and velocity of external objects in relation to the equipped vehicle. A particularly sensitive part of the camera device is the mechanics that determine the lens versus image sensor distance. This distance must be kept within a very small region of variations throughout the lifetime and temperature conditions of the vehicle. It is therefore very important that external forces adding to the environmental and aging effects are as small as possible.

The common set-up for a vehicle camera device is that it communicates and is power-supplied via one harness that for example comprises a shielded cable terminated by a multi pin connector, or coaxial bi-polar connector. Any motion and/or weight load transferred from the harness must be absorbed by the mating connector and strain relief of the vehicle camera device to avoid disturbances of the images produced by the vehicle camera device.

In order to overcome the effect of motion and/or weight load transferred from the harness, the image sensor and the external connector have previously been mounted to two separate circuit boards with flexible electrical and mechanical connections between them. This design introduces higher material costs, higher assembly costs and larger dimensions.

US 2021/041768 A1 discloses a vehicle camera that includes a lens holder and an imager printed circuit board. The lens holder is attached to an imager printed circuit board by adhesively bonding four posts that protrude from a rear side of the lens holder to the imager printed circuit board. A header connector is secured to the imager printed circuit board and is adapted to receive the electrical connector portion.

US 2009/244361 A1 discloses a lens mounting portion that includes outer side walls that cooperate to define a cavity or pocket for receiving the circuit board therein. The circuit board is secured or attached or mounted to lens mounting portion via a pair of fasteners that extend through openings in or through circuit board and into openings. A connector is positioned centrally on the circuit board.

US 2014/002659 A1 discloses a vision system where a circuit board is mounted at a fixed position on the front housing member by circuit board mounting fasteners which are received in a plurality of apertures in the front housing member. The apertures are formed in protruding members in the housing member. A connector is positioned centrally on the circuit board.

US 2022/030145 A1 discloses a vehicular camera where the optical components of a lens and a camera front housing form a single integrated piece that is dropped onto and sits directly on top of the surface of an imager.

It is therefore an object of the present disclosure to overcome the effect of motion and/or weight load transferred to the vehicle camera circuit board from the harness while providing compact dimensions.

Said object is achieved by means of vehicle camera circuit board comprising a first main side and a second main side. The first main side comprises an imaging sensor and a contact area that is adapted to face a contact part of a lens assembly. The second main side comprises an attachment area adapted to receive a first connector part. The attachment area is partly overlapping the contact area when seen against a main side.

In this way, the attachment area enables the first connector part to be placed at a mechanically favorable position on the vehicle camera circuit board; close to and on the opposite side of the supporting surface, the contact area, where the lens assembly is adapted to be attached. The lens assembly is typically made out of metal or hard glass reinforced plastics, and can therefore serve a mechanically rigid support for the vehicle camera circuit board in certain bending situations for the first connector part. This counteracts the negative impact of image disturbances from external forces through a harness via the first connector part.

According to some aspects, the contact area comprises an adhesive that is adapted to attach to the contact part.

In this way, the contact area can be securely attached to the contact part in a sealed manner.

According to some aspects, the attachment area is positioned mainly within the circumference of the contact area.

According to some aspects, the attachment area is positioned mainly outside the circumference of the contact area.

According to some aspects, the attachment area is positioned where the circumference of the contact area performs a change of direction along its extension.

According to some aspects, the attachment area is positioned where the circumference of the contact area follows a straight extension direction.

This means that there exist many ways to position the attachment area within the scope of the present disclosure.

This object is also achieved by means of vehicle camera modules, vehicles and methods associated with the above advantages.

### BRIEF DESCRIPTION OF THE DRAWINGS

The present disclosure will now be described more in detail with reference to the appended drawings, where:
- Figure 1: shows a schematic cut-open part of a vehicle with a camera device;
- Figure 2: shows a schematic perspective front view of a vehicle camera module;
- Figure 3: shows a first exploded perspective view of the vehicle camera module;
- Figure 4: shows a second exploded perspective view of the vehicle camera module;
- Figure 5: shows a perspective view of a vehicle camera circuit board without connector part mounted;
- Figure 6: shows a perspective view of a vehicle camera circuit board with first connector part mounted;
- Figure 7A: shows a side view of a vehicle camera circuit board with first connector part mounted;
- Figure 7B: shows a first main side view of a vehicle camera circuit board with first connector part mounted;
- Figure 8: shows a perspective view of a first connector part;
- Figure 9: shows a perspective view of a vehicle camera circuit board with both connector parts mounted;
- Figure 10-11: show a first main side view of a vehicle camera circuit board without connector part mounted according to different examples; and
- Figure 12: shows a flowchart for methods according to the present disclosure.

### DETAILED DESCRIPTION

Aspects of the present disclosure will now be described more fully hereinafter with reference to the accompanying drawings. The different devices, systems, computer programs and methods disclosed herein can, however, be realized in many different forms and should not be construed as being limited to the aspects set forth herein. Like numbers in the drawings refer to like elements throughout.

The terminology used herein is for describing aspects of the disclosure only and is not intended to limit the invention. As used herein, the singular forms "a", "an" and "the" are intended to include the plural forms as well, unless the context clearly indicates otherwise.

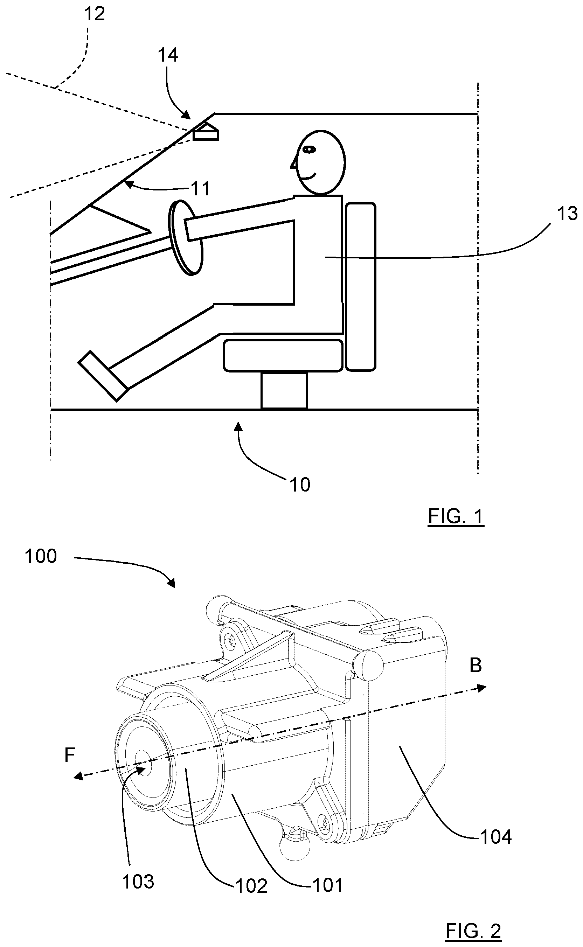

Figure 1 schematically shows a cut-open part of a vehicle 10, where the vehicle 10 comprises a vehicle camera arrangement 14 attached to a vehicle windscreen 11. The vehicle camera arrangement 14 is arranged for capturing images of the surroundings outside the vehicle 10 by means of a certain field of view 12. The vehicle camera arrangement 14 can also, or alternatively, be arranged for capturing images of a driver 13, where these images, which may include eye movements, for example can be used for detecting a degree of driver drowsiness.

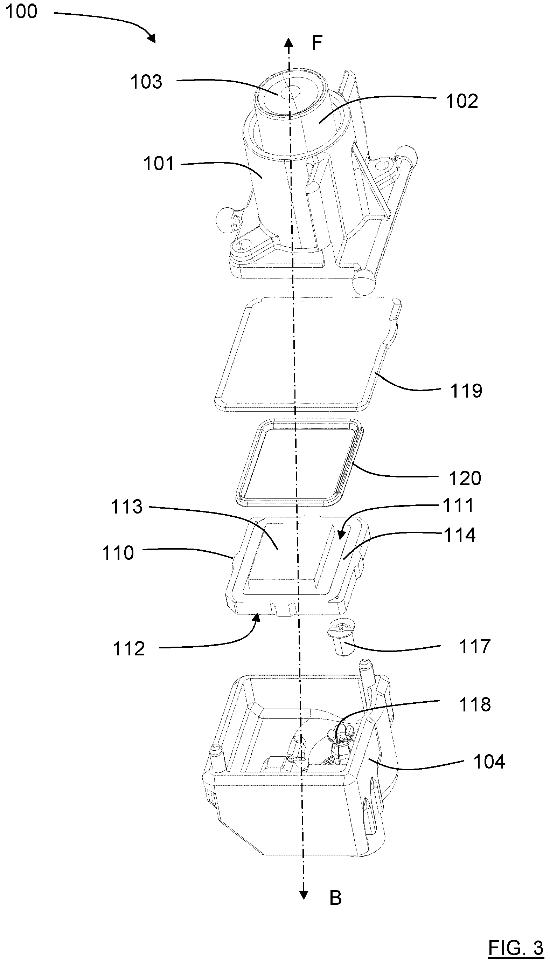

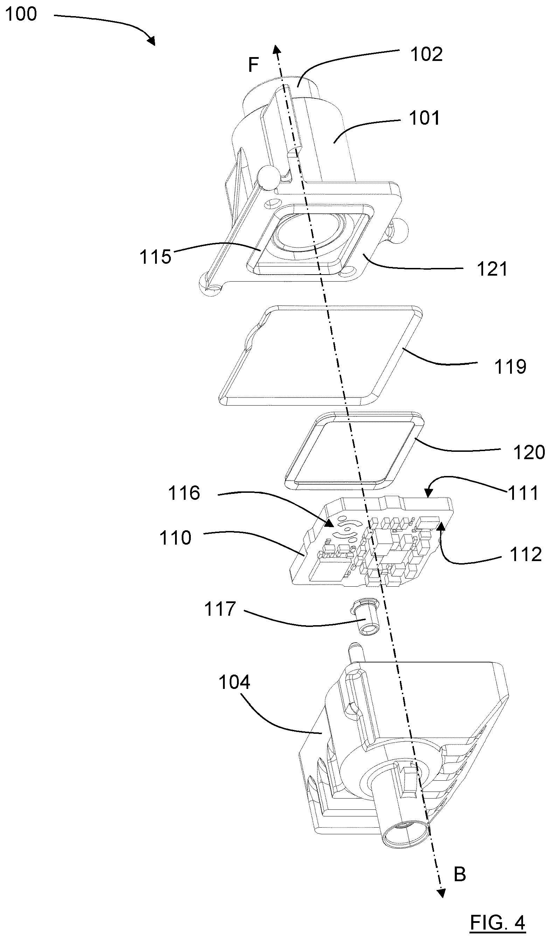

Figure 2 shows a side perspective view of a vehicle camera module 100 that is comprised in the vehicle camera arrangement 14, and Figure 3 and Figure 4 show exploded perspective views of the vehicle camera module 100.

The vehicle camera module 100 comprises a lens assembly 101. According to some aspects, the vehicle camera module 100 comprises a lens barrel 102, a lens aperture 103, a gasket 119 and a cover part 104 that is adapted to be mounted to the lens assembly 101, where the gasket 119 is adapted to provide sealing between the lens assembly 101 and the cover part 104.

The vehicle camera module 100 further comprises a vehicle camera circuit board 110, and a connector assembly 117, 118. The connector assembly in turn comprises a first connector part 117 and a second connector part 118, where the first connector part 117 is attached to an attachment area 116a, 116b and the lens assembly 101 is attached to the vehicle camera circuit board 110 such that a contact part 115 of the lens assembly 101 faces the contact area 114.

According to some aspects, the contact part 115 is formed in a flange part 121 that is adapted to be mounted to the cover part 104.

A forward direction F is directed from the cover part 104 towards the lens aperture 103, and a backward direction B is directed in the opposite direction is indicated in Figure 2-4.

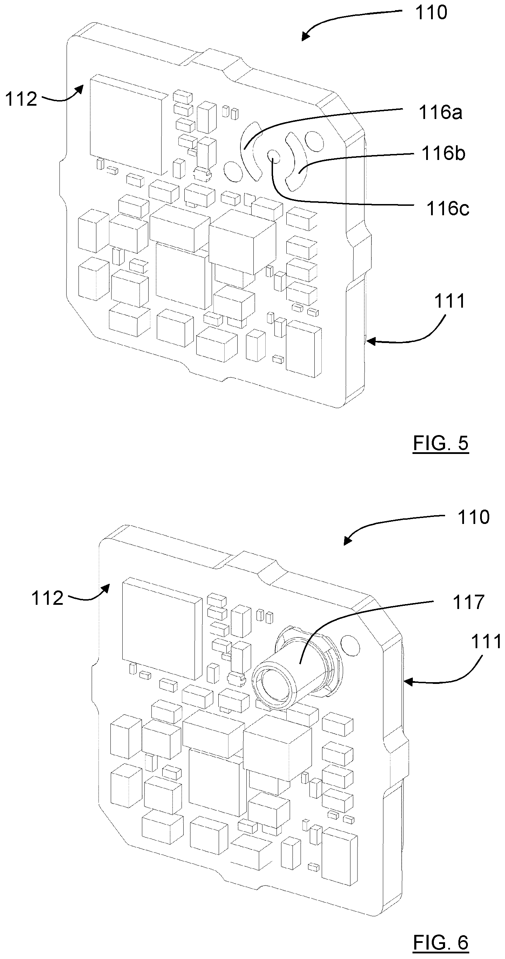

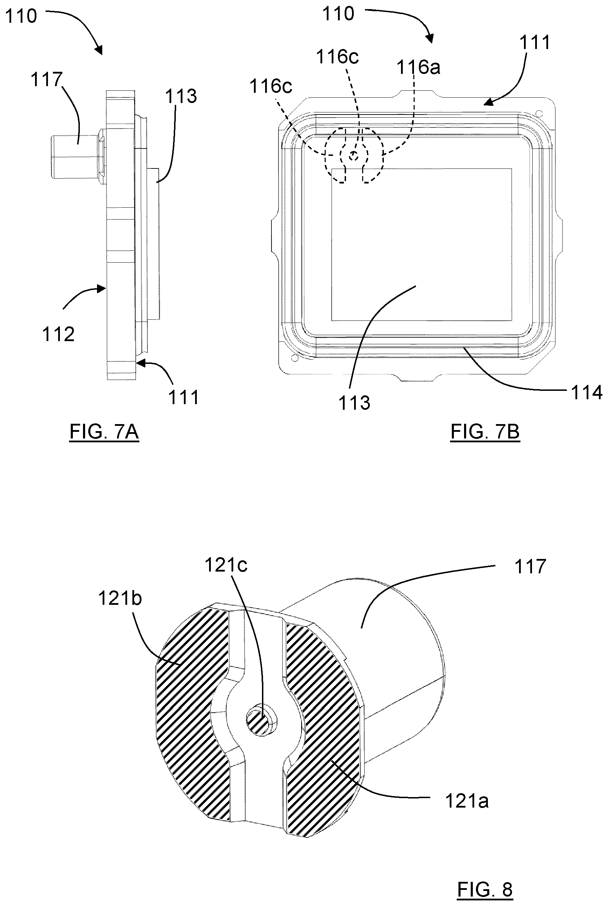

The vehicle camera circuit board 110 will now be described more in detail, with reference also to Figure 5-8. Figure 5 shows a perspective view of a vehicle camera circuit board without connector part mounted, Figure 6 shows a perspective view of a vehicle camera circuit board with connector part mounted, Figure 7A shows a side view of a vehicle camera circuit board with connector part mounted, Figure 7B shows a first main side view of a vehicle camera circuit board with connector part mounted, and Figure 8 shows a perspective view of a connector part.

The vehicle camera circuit board 110 comprises a first main side 111 and a second main side 112, where the first main side 111 comprises an imaging sensor 113 and a contact area 114 that is adapted to face the contact part 115 of the lens assembly 101. The second main side 112 comprises an attachment area 116a, 116b, 116c adapted to receive a first connector part 117. According to the present disclosure, the attachment area 116a, 116b 116c is partly overlapping the contact area 114 when seen against a main side 111, 112.

In this way, the attachment area 116a, 116b 116c enables the first connector part 117 to be placed at a mechanically favorable position on the vehicle camera circuit board 110; close to and on the opposite side of the supporting surface, the contact area 114, where the lens assembly 101 is adapted to be attached. The lens assembly 101 is typically made out of metal or hard glass reinforced plastics, and can therefore serve a mechanically rigid support for the vehicle camera circuit board 110 in certain bending situations for the first connector part 117. This counteracts the negative impact of image disturbances from external forces through a harness via the first connector part 117.

According to some aspects, the first connector part 117 will to some defined distance be adapted to absorb the assembly tolerance in a controlled way, and have the main fixation in a mechanically robust cover that encapsulates the vehicle camera circuit board 110.

This means that imaging stability is improved by reduced mechanical interference. Furthermore, since no separate printed circuit board is needed for mounting the first connector part 117, there is a reduced number of parts in Bill of Materials (BoM), a reduced number of assembly process steps, reduced dimensions and weight of the complete vehicle camera module 100.

The positive effect by the positioning of the attachment area 116a, 116b 116c is due to the fact that by placing a load on a flat membrane far from supporting elements, e.g., in the center of a drum head, will deflect the membrane more than placing the load close to the support, i.e., near the rim of the drum head.

This is a fact for all kinds of loads, straight or by torque. As vehicle camera circuit board 110 typically can be modeled as a membrane of certain dimensions, having a thickness, width and length with usually a supporting interface close to the outer boundaries or perimeter of the membrane, it is therefore possible to identify areas where an external force is more prone to deflect the vehicle camera circuit board 110, and thus affect the imaging sensor 113, than others.

The attachment area can be constituted by one coherent area or, as in this case, several separate sub-areas 116a, 116b, 116c. According to some aspects the attachment area 116a, 116b 116c forms a so-called footprint.

According to some aspects, the contact area 114 comprises an adhesive 120 that is adapted to attach to the contact part 115.

According to some aspects, the adhesive 120 is a separate item, where the vehicle camera module 100 comprises the adhesive 120, where the lens assembly 101 is attached to the vehicle camera circuit board 110 by means of the adhesive 120.

Figure 8 shows the first connector part 117 that comprises interface area 121a, 121b, 121c that is adapted to be attached to the attachment area 116a, 116b, 116c, for example by means of soldering or gluing with electrically conducting glue. Normally, the interface area 121a, 121b, 121c is intended to be electrically connected to the attachment area 116a, 116b, 116c such that some sub-areas 116a, 116b of the attachment area correspond to ground sub-areas 121a, 121b of the interface area and a another sub-area 116c of the attachment area corresponds to a signal conductor sub-area 121c of the interface area.

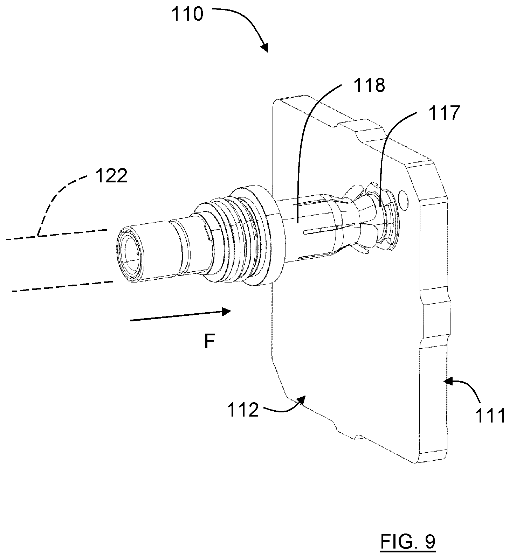

Figure 9 shows a simplified perspective view of the first connector part 117 that is attached to the vehicle camera circuit board 110 (no other components shown). Furthermore, the second connector part 118 is attached to the first connector part 117. Figure 9 thus illustrates how a force from a cable 122 (only schematically indicated) is transferred to the second connector part 118, to the first connector part 117 and to the vehicle camera circuit board 110. According to some aspects, the cable 122 is inserted mainly in the forward direction F.

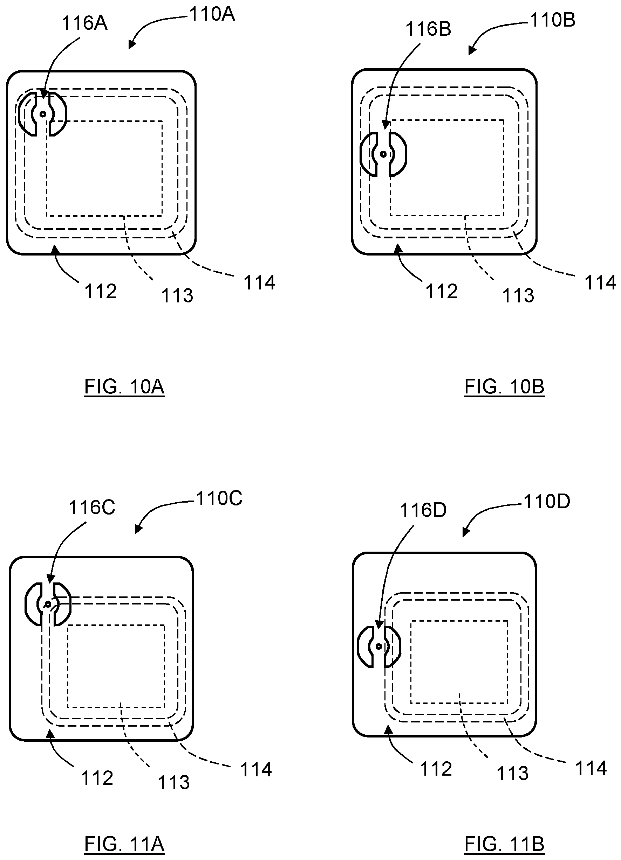

A few examples of how the attachment area can be positioned according to some aspects of the present disclosure follow below with reference to Figure 10-11.

Figure 10A, Figure 10B, Figure 11A and Figure 11B show the first main side 112 of the vehicle camera circuit board 110A, 110B, 110C, 110D, without the connector part mounted.

Figure 10A shows a first placement of the attachment area 116A and Figure 10B shows a second placement of the attachment area 116B. For both these placements the attachment area 116A, 116B is positioned mainly within the circumference of the contact area 114.

Figure 11A shows a third placement of the attachment area 116C and Figure 11B shows a fourth placement of the attachment area 116D. For both these placements the attachment area 116C, 116D is positioned mainly outside the circumference of the contact area 114.

For the first and third placement of the attachment area 116A, 116C, the attachment area 116A, 116C is positioned where the circumference of the contact area 114 performs a change of direction along its extension.

For the second and fourth placement of the attachment area 116B, 116D, the attachment area 116B, 116D is positioned where the circumference of the contact area 114 follows a straight extension direction.

These examples are only to show a few different placements, the attachment area can of course be positioned in a large number of ways while partly overlapping the contact area 114 when seen against a main side 111, 112.

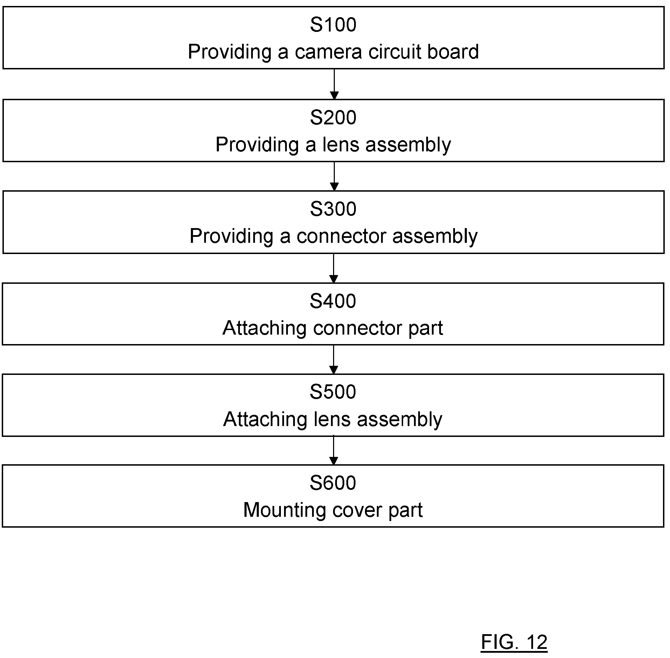

With reference to Figure 12, the present disclosure also relates to a method for mounting a vehicle camera module 100 comprising providing S100 a camera circuit board 110 according to the above, providing S200 a lens assembly 101, and providing S300 a connector assembly 117, 118 with a first connector part 117. The method further comprises attaching S400 the first connector part 117 to the attachment area 116a, 116b, 116c, attaching S500 the lens assembly 101 to the vehicle camera circuit board 110 such that a contact part 115 of the lens assembly 101 faces the contact area 114, and mounting S600 a cover part 104 to the lens assembly 101.

According to some aspects, the attachment area 116A, 116B is positioned mainly within the circumference of the contact area 114.

According to some aspects, the attachment area 116C, 116D is positioned mainly outside the circumference of the contact area 114.

According to some aspects, the attachment area 116A, 116C is positioned where the circumference of the contact area 114 performs a change of direction along its extension.

According to some aspects, the attachment area 116B, 116D is positioned where the circumference of the contact area 114 follows a straight extension direction.

The present disclosure is not limited to the examples above, but may vary freely within the scope of the appended claims.

## Claims

1. A vehicle camera circuit board (110) comprising a first main side (111) and a second main side (112), where the first main side (111) comprises an imaging sensor (113) and a circumferentially running contact area (114) that circumvents the imaging sensor (113) and is adapted to face a contact part (115) of a lens assembly (101) where the lens assembly is adapted to be attached, and where the second main side (112) comprises an attachment area (116a, 116b, 116c) adapted to receive a first connector part (117), wherein the attachment area (116a, 116b, 116c) is partly overlapping the contact area (114) when seen against a main side (111, 112).

2. The vehicle camera circuit board (110) according to claim 1, wherein the contact area (114) comprises an adhesive (120) that is adapted to attach to the contact part (115).

3. The vehicle camera circuit board (110A, 110B) according to any one of the claims 1 or 2, wherein the attachment area (116A, 116B) is positioned mainly within the circumference of the contact area (114).

4. The vehicle camera circuit board (110C, 110D) according to any one of the claims 1 or 2, wherein the attachment area (116C, 116D) is positioned mainly outside the circumference of the contact area (114).

5. The vehicle camera circuit board (110C, 110D) according to any one of the previous claims, wherein the attachment area (116A, 116C) is positioned where the circumference of the contact area (114) performs a change of direction along its extension.

6. The vehicle camera circuit board (110C, 110D) according to any one of the claims 1-4, wherein the attachment area (116B, 116D) is positioned where the circumference of the contact area (114) follows a straight extension direction.

7. A vehicle camera module (100) comprising the vehicle camera circuit board (110) according to any one of the claims 1-6, a lens assembly (101) and a connector assembly (117, 118), where the connector assembly comprises a first connector part (117) that is attached to the attachment area (116a, 116b, 116c) and where the lens assembly (101) is attached to the vehicle camera circuit board (110) such that a contact part (115) of the lens assembly (101) faces the contact area (114).

8. The vehicle camera module (100) according to claim 7, wherein the vehicle camera module (100) comprises an adhesive (120), and where the lens assembly (101) is attached to the vehicle camera circuit board by (110) means of the adhesive.

9. A method for mounting a vehicle camera module (100) comprising
providing (S100) a camera circuit board (110) according to any one of the claims 1-6;
providing (S200) a lens assembly (101);
providing (S300) a connector assembly (117, 118) with a first connector part (117);
attaching (S400) the first connector part (117) to the attachment area (116a, 116b, 116c);
attaching (S500) the lens assembly (101) to the vehicle camera circuit board (110) such that a contact part (115) of the lens assembly (101) faces the contact area (114); and
mounting (S600) a cover part (104) to the lens assembly (101).

10. The method according to claim 9, wherein the attachment area (116A, 116B) is positioned mainly within the circumference of the contact area (114).

11. The method according to any one of the claims 9 or 10, wherein the attachment area (116C, 116D) is positioned mainly outside the circumference of the contact area (114).

12. The method according to any one of the claims 9-11, wherein the attachment area (116A, 116C) is positioned where the circumference of the contact area (114) performs a change of direction along its extension.

13. The method according to any one of the claims 9-11, wherein the attachment area (116B, 116D) is positioned where the circumference of the contact area (114) follows a straight extension direction.

14. A vehicle (10) comprising the vehicle camera module (100) according to any one of the claims 7 or 8.

## Patentansprüche

1. Fahrzeugkamera-Leiterplatte (110), umfassend eine erste Hauptseite (111) und eine zweite Hauptseite (112), wobei die erste Hauptseite (111) einen Bildsensor (113) und einen umlaufenden Kontaktbereich (114) umfasst, der den Bildsensor (113) umgibt und angepasst ist, um einem Kontaktteil (115) einer Linsenanordnung (101) zugewandt zu sein, wobei die Linsenanordnung angepasst ist, um daran befestigt zu werden, und wobei die zweite Hauptseite (112) einen Befestigungsbereich (116a, 116b, 116c), der angepasst ist, um ein erstes Verbinderteil (117) aufzunehmen, umfasst, wobei der Befestigungsbereich (116a, 116b, 116c) von einer Hauptseite (111, 112) aus gesehen den Kontaktbereich (114) teilweise überlappt.

2. Fahrzeugkamera-Leiterplatte (110) nach Anspruch 1, wobei der Kontaktbereich (114) einen Klebstoff (120), der angepasst ist, um an dem Kontaktteil (115) zu befestigen, umfasst.

3. Fahrzeugkamera-Leiterplatte (110A, 110B) nach einem der Ansprüche 1 oder 2, wobei der Befestigungsbereich (116A, 116B) hauptsächlich innerhalb des Umfangs des Kontaktbereichs (114) positioniert ist.

4. Fahrzeugkamera-Leiterplatte (110C, 110D) nach einem der Ansprüche 1 oder 2, wobei der Befestigungsbereich (116C, 116D) hauptsächlich außerhalb des Umfangs des Kontaktbereichs (114) positioniert ist.

5. Fahrzeugkamera-Leiterplatte (110C, 110D) nach einem der vorhergehenden Ansprüche, wobei der Befestigungsbereich (116A, 116C) dort positioniert ist, wo der Umfang des Kontaktbereichs (114) entlang seiner Ausdehnung eine Richtungsänderung durchführt.

6. Fahrzeugkamera-Leiterplatte (110C, 110D) nach einem der Ansprüche 1 bis 4, wobei der Befestigungsbereich (116B, 116D) dort positioniert ist, wo der Umfang des Kontaktbereichs (114) einer geraden Ausdehnungsrichtung folgt.

7. Fahrzeugkameramodul (100), umfassend die Fahrzeugkamera-Leiterplatte (110) nach einem der Ansprüche 1 bis 6, eine Linsenanordnung (101) und eine Verbinderanordnung (117, 118) umfasst, wobei die Verbinderanordnung ein erstes Verbinderteil (117), das an dem Befestigungsbereich (116a, 116b, 116c) befestigt ist, umfasst, und wobei die Linsenanordnung (101) derart an der Fahrzeugkamera-Leiterplatte (110) befestigt ist, dass ein Kontaktteil (115) der Linsenanordnung (101) dem Kontaktbereich (114) zugewandt ist.

8. Fahrzeugkameramodul (100) nach Anspruch 7, wobei das Fahrzeugkameramodul (100) einen Klebstoff (120) umfasst, und wobei die Linsenanordnung (101) mittels des Klebstoffs an der Fahrzeugkamera-Leiterplatte (110) befestigt ist.

9. Verfahren zum Montieren eines Fahrzeugkameramoduls (100), umfassend
Bereitstellen (S100) einer Kamera-Leiterplatte (110) nach einem der Ansprüche 1 bis 6;
Bereitstellen (S200) einer Linsenanordnung (101);
Bereitstellen (S300) einer Verbinderanordnung (117, 118) mit einem ersten Verbinderteil (117);
Befestigen (S400) des ersten Verbinderteils (117) an dem Befestigungsbereich (116a, 116b, 116c);
derart Befestigen (S500) der Linsenanordnung (101) an der Fahrzeugkamera-Leiterplatte (110), dass ein Kontaktteil (115) der Linsenanordnung (101) dem Kontaktbereich (114) zugewandt ist; und
Montieren (S600) eines Abdeckungsteils (104) an der Linsenanordnung (101).

10. Verfahren nach Anspruch 9, wobei der Befestigungsbereich (116A, 116B) hauptsächlich innerhalb des Umfangs des Kontaktbereichs (114) positioniert ist.

11. Verfahren nach einem der Ansprüche 9 oder 10, wobei der Befestigungsbereich (116C, 116D) hauptsächlich außerhalb des Umfangs des Kontaktbereichs (114) positioniert ist.

12. Verfahren nach einem der Ansprüche 9 bis 11, wobei der Befestigungsbereich (116A, 116C) dort positioniert ist, wo der Umfang des Kontaktbereichs (114) entlang seiner Ausdehnung eine Richtungsänderung durchführt.

13. Verfahren nach einem der Ansprüche 9 bis 11, wobei der Befestigungsbereich (116B, 116D) dort positioniert ist, wo der Umfang des Kontaktbereichs (114) einer geraden Ausdehnungsrichtung folgt.

14. Fahrzeug (10), umfassend das Fahrzeugkameramodul (100) nach einem der Ansprüche 7 oder 8.

## Revendications

1. Carte de circuit imprimé de caméra de véhicule (110) comprenant un premier côté principal (111) et un second côté principal (112), où le premier côté principal (111) comprend un capteur d'imagerie (113) et une zone de contact circonférentielle (114) qui contourne le capteur d'imagerie (113) et est conçue pour faire face à une partie de contact (115) d'un ensemble objectif (101) où l'ensemble objectif est conçu pour être fixé, et où le second côté principal (112) comprend une zone de fixation (116a, 116b, 116c) conçue pour recevoir une première partie de connecteur (117), dans laquelle la zone de fixation (116a, 116b, 116c) chevauche partiellement la zone de contact (114) lorsqu'elle est vue par rapport à un côté principal (111, 112).

2. Carte de circuit imprimé de caméra de véhicule (110) selon la revendication 1, dans laquelle la zone de contact (114) comprend un adhésif (120) qui est conçu pour se fixer à la partie de contact (115).

3. Carte de circuit imprimé de caméra de véhicule (110A, 110B) selon l'une quelconque des revendications 1 ou 2, dans laquelle la zone de fixation (116A, 116B) est positionnée principalement à l'intérieur de la circonférence de la zone de contact (114).

4. Carte de circuit imprimé de caméra de véhicule (110C, 110D) selon l'une quelconque des revendications 1 ou 2, dans laquelle la zone de fixation (116C, 116D) est positionnée principalement à l'extérieur de la circonférence de la zone de contact (114).

5. Carte de circuit imprimé de caméra de véhicule (110C, 110D) selon l'une quelconque des revendications précédentes, dans laquelle la zone de fixation (116A, 116C) est positionnée là où la circonférence de la zone de contact (114) effectue un changement de direction le long de son extension.

6. Carte de circuit imprimé de caméra de véhicule (110C, 110D) selon l'une quelconque des revendications 1 à 4, dans laquelle la zone de fixation (116B, 116D) est positionnée là où la circonférence de la zone de contact (114) suit une direction d'extension rectiligne.

7. Module de caméra de véhicule (100) comprenant la carte de circuit imprimé de caméra de véhicule (110) selon l'une quelconque des revendications 1 à 6, un ensemble objectif (101) et un ensemble connecteur (117, 118), où l'ensemble connecteur comprend une première partie de connecteur (117) qui est fixée à la zone de fixation (116a, 116b, 116c) et où l'ensemble objectif (101) est fixé à la carte de circuit imprimé de caméra de véhicule (110) de telle sorte qu'une partie de contact (115) de l'ensemble objectif (101) se trouve face à la zone de contact (114).

8. Module de caméra de véhicule (100) selon la revendication 7, dans lequel le module de caméra de véhicule (100) comprend un adhésif (120), et où l'ensemble objectif (101) est fixé à la carte de circuit imprimé de caméra de véhicule (110) au moyen de l'adhésif.

9. Procédé de montage d'un module de caméra de véhicule (100) comprenant
la fourniture (S100) d'une carte de circuit imprimé de caméra (110) selon l'une quelconque des revendications 1 à 6 ;
la fourniture (S200) d'un ensemble objectif (101) ;
la fourniture (S300) d'un ensemble connecteur (117, 118) comportant une première partie de connecteur (117) ;
la fixation (S400) de la première partie de connecteur (117) à la zone de fixation (116a, 116b, 116c) ;
la fixation (S500) de l'ensemble objectif (101) à la carte de circuit imprimé de caméra du véhicule (110) de telle sorte qu'une partie de contact (115) de l'ensemble objectif (101) se trouve face à la zone de contact (114) ; et
le montage (S600) d'un élément de couverture (104) sur l'ensemble objectif (101).

10. Procédé selon la revendication 9, dans lequel la zone de fixation (116A, 116B) est positionnée principalement à l'intérieur de la circonférence de la zone de contact (114).

11. Procédé selon l'une quelconque des revendications 9 ou 10, dans lequel la zone de fixation (116C, 116D) est positionnée principalement à l'extérieur de la circonférence de la zone de contact (114).

12. Procédé selon l'une quelconque des revendications 9 à 11, dans lequel la zone de fixation (116A, 116C) est positionnée là où la circonférence de la zone de contact (114) effectue un changement de direction le long de son extension.

13. Procédé selon l'une quelconque des revendications 9 à 11, dans lequel la zone de fixation (116B, 116D) est positionnée là où la circonférence de la zone de contact (114) suit une direction d'extension rectiligne.

14. Véhicule (10) comprenant le module de caméra de véhicule (100) selon l'une quelconque des revendications 7 ou 8.
